# EUROPÄISCHE PATENTSCHRIFT

(11) **EP 1 959 570 B1**
(45) Veröffentlichungstag und Bekanntmachung des Hinweises auf die Patenterteilung: **30.09.2009**
(21) Anmeldenummer: 08002554.7
(22) Anmeldetag: 12.02.2008
(51) Int. Cl.: H03K 17/95

(54) **Induktiver Nährungssensor**
Inductive proximity sensor
Détecteur d'approximation inductif

(30) Priorität: 15.02.2007 DE 102007007551
(43) Veröffentlichungstag der Anmeldung: 20.08.2008
(73) Patentinhaber: SICK AG, 79183 Waldkirch/Breisgau (DE)
(72) Erfinder: Machul, Olaf, Dr., 79104 Freiburg (DE); Thoss, Sascha, 47137 Duisburg (DE)
(74) Vertreter: Manitz, Finsterwald & Partner GbR

(56) Entgegenhaltungen:
- PATRICK GAYDECKI ET AL: "Design and evaluation of an inductive Q-detection sensor incorporating digital signal processing for imaging of steel reinforcing bars in concrete; An inductive Q-detection sensor incorporating DSP" MEASUREMENT SCIENCE AND TECHNOLOGY, IOP, BRISTOL, GB, Bd. 13, Nr. 8, 1. August 2002 (2002-08-01), Seiten 1327-1335, XP020063590 ISSN: 0957-0233
- WEILER D ET AL: "Detection of Defective Sensor Elements Using Y-A-Modulation and a Matched Filter" 20000327; 20000327 - 20000330, 27. März 2000 (2000-03-27), Seiten 599-603, XP010377523
- MOLCOVATI P ET AL: "SMART SENSOR INTERFACE WITH A/D CONVERSION AND PROGRAMMABLE CALIBRATION" IEEE JOURNAL OF SOLID-STATE CIRCUITS, IEEE SERVICE CENTER, PISCATAWAY, NJ, US, Bd. 29, Nr. 8, 1. August 1994 (1994-08-01), Seiten 963-966, XP000460922 ISSN: 0018-9200
- LEME C A ET AL: "Flexible architecture for CMOS sensor interfaces" PROCEEDINGS OF THE INTERNATIONAL SYMPOSIUM ON CIRCUITS AND SYSTEMS. SAN DIEGO, MAY 10 - 13, 1992; [PROCEEDINGS OF THE INTERNATIONAL SYMPOSIUM ON CIRCUITS AND SYSTEMS. (ISCAS)], NEW YORK, IEEE, US, Bd. 4, 3. Mai 1992 (1992-05-03), Seiten 1828-1831, XP010061531 ISBN: 978-0-7803-0593-9

## Beschreibung

Die Erfindung betrifft einen induktiven Näherungssensor mit einem Sensorelement, welches einen Schwingkreis umfasst, dessen Ausgangssignal von der Bedämpfung durch ein elektrisch leitfähiges Objekt abhängt, und ein Verfahren zur Feststellung der Anwesenheit und/oder des Abstandes eines elektrisch leitfähigen Objektes.

Induktive Näherungssensoren detektieren elektrisch leitfähige Metalle auf Grundlage des Wirbelstromprinzips. Mittels eines elektrischen Schwingkreises aus einer Spule und einem Kondensator (LC-Schwingkreis) wird ein magnetisches Wechselfeld aufgebaut, das über die Spule des Schwingkreises in den Raum gerichtet abgestrahlt wird. Gelangt ein elektrisch leitfähiges Objekt (im Folgenden auch "Target") in den Wirkungsbereich des Wechselfeldes, werden durch das Wechselfeld im Target Wirbelströme induziert, die wiederum ein Magnetfeld hervorrufen, das dem anregenden Magnetfeld entgegengesetzt gerichtet ist. Die Erzeugung der Wirbelströme entzieht dem anregenden Magnetfeld Energie und beeinflusst damit die Impedanz der Spule bzw. dämpft den LC-Schwingkreis. Ein Ausgangssignal des LC-Schwingkreises, z.B. dessen Schwingungsamplitude, stellt ein Maß für dessen Dämpfung dar, das die Detektion des metallischen Objekts erlaubt. Bei dem Objekt kann es sich zum Beispiel um eine Schaltfahne handeln, die über den Näherungssensor ein Schaltsignal auslösen kann.

Da das magnetische Feld im Nahbereich mit der dritten Potenz in den Raum hinein abnimmt, wird es mit größer werdendem Abstand des Targets von der Spule immer schwieriger, das Target mit einer ausreichenden Genauigkeit zu detektieren. Der gemäß IEC 60947-5-2/EN 60947-5-2 bestimmte Abstand eines genormten Targets von dem induktiven Näherungssensor, bei dem ein sicheres Erkennen des Targets gewährleistet ist, wird als Nennschaltabstand bezeichnet und beträgt in der Regel wenige Millimeter. Zur Erzielung möglichst hoher Schaltabstände, die über den Nennschaltabstand hinausgehen, trägt neben einer hohen Temperaturstabilität des Sensors eine möglichst hoch aufgelöste Auslesung des Sensorsignals bei.

Üblicherweise wird eine Änderung des Realteils der Spulenimpedanz bzw: des Dämpfungswiderstands ausgewertet, um die Anwesenheit eines Targets zu detektieren. Um bei großen Schaltabständen, z.B. dem 3- oder 4-fachen des Nennschaltabstandes, eine entsprechend geringer ausfallende Veränderung des Realteils der Spulenimpedanz detektieren zu können, werden hochauflösende Signaltechniken mit ausreichend großem Signal/Rauschabstand benötigt. Die maximal mögliche physikalische Auflösung wird durch das Rauschen des LC-Schwingkreises begrenzt.

Ein im Stand der Technik übliches und oft verwendetes Detektionsverfahren umfasst beispielsweise die Gleichrichtung des Ausgangssignals des LC-Schwingkreises mit anschließender Filterung und den abschließenden Vergleich des gefilterten Signals mit einer Schaltschwelle über einen Komparator. Bei induktiven Näherungssensoren, die nach diesem Prinzip arbeiten, begrenzt die Güte der Gleichrichtung und des Komparators die erreichbare Auflösung. Zur Erzielung hoher Schaltabstände bei derartigen induktiven Näherungssensoren ist ein erheblicher Aufwand bei der Produktion und beim Abgleich der Sensoren notwendig.

In "Design and evaluation of an inductive Q-detection sensor incorporating digital signal processing for imaging af steel reinforcing bars in concrete; An inductive Q-detection sensor incorporating DSP" von Patrick Gaydecky et al.,Measurement Science and Technology, IOP, Bristol, GB, Bd. 13, Nr. 8, 1. August 2002, Seiten 1327-1335 ist ein induktiver Näherungssensor nach dem Oberbegriff von Anspruch 1 offenbart.

Weiler et al. verwenden in "Detection of Defective Sensor Elements Using ΣΔ-Modulation and a Matched Filter", IEEE 2000, 27. März 2000, Seiten 599-603 einen ΣΔ-Modulators zur Detektion fehlerhafter Sensoren.

In "Smart Sensor Interface with A/D-Conversion and Programmable Calibration" von Malcovati et al., IEEE Journal Of Solid-State Circuits, IEEE Service Center, Piscataway, NJ, US, Bd. 29, Nr. 8, 1. August 1994, Seiten 963-966 ist eine Sensorschnittstelle offenbart, die einen ΣΔ-Modulator zur A/D-Wandlung der Sensorsignale einsetzt.

Leme C. A. et al. offenbaren in "Flexible Architecture for CMOS Sensor Interfaces", Proceedings of the International Symposium on Circuits and Systems (ISCAS), New York, IEEE, US, Bd. 4, 3.May 1992, Seiten 1828-1831, XP010061531, ISBN:978-0-7803-0593-9 eine Schnittstellenarchitektur für CMOS-Sensoren, die einen ΣΔ-Modulator zur A/D-Wandlung der Sensorsignale einsetzt.

Der Erfindung liegt die Aufgabe zugrunde, einen induktiven Näherungssensor mit möglichst hohem Schaltabstand und sicherem und robustem Betrieb zu ermöglichen, insbesondere eine möglichst hoch auflösende Bestimmung eines Ausgangssignals eines Schwingkreises zu erreichen.

Diese Aufgabe wird mit einem induktiven Näherungssensor mit den Merkmalen des Anspruchs 1 gelöst. Bevorzugte Ausführungsformen sind Gegenstand von Unteransprüchen.

Der erfindungsgemäße induktive Näherungssensor zeichnet sich dadurch aus, dass er zur Auswertung eines Ausgangssignals des Schwingkreises, insbesondere eines LC-Schwingkreises, einen ΣΔ-Modulator (Sigma-Delta-Modulator) verwendet. Der Schwingkreis des Sensorelements liefert ein Ausgangssignal, das durch eine Bedämpfung aufgrund der Anwesenheit eines elektrisch leitfähigen Targets beeinflusst wird. Dieses Ausgangssignal wird dem Eingang des ΣΔ-Modulators zugeführt und von diesem durch ein Filter, im Folgenden auch Schleifenfilter genannt, an einen A/D-Wandler geführt, an dessen Ausgang ein pulshäufigkeitsmodulierter Datenstrom ausgegeben wird. Dieser Datenstrom wird über einen D/A-Wandler zurückgekoppelt.

Die frühe Überführung des analogen Schwingkreisausgangs in ein digitales Signal trägt zur Robustheit des erfindungsgemäßen induktiven Näherungssensors gegenüber äußeren elektromagnetischen Störeinflüssen bei. Der erzeugte pulshäufigkeitsmodulierte Datenstrom am Ausgang des A/D-Wandlers enthält Information über den Dämpfungswiderstand des Schwingkreises in digitaler, hoch linearer und hoch aufgelöster Form. Die hohe Auflösung wird aufgrund der Noise-Shaping Eigenschaft des ΣΔ-Modulators begünstigt, durch welche Störeinflüsse (z.B. weißes Rauschen) weitgehend unterdrückt werden können. Die damit erreichbare Genauigkeit und das Vorliegen der Information in digitaler Form ermöglichen einen Einsatz des induktiven Näherungssensors nicht nur zur Erzeugung von Schaltsignalen (binärer Sensor), sondern auch zur genauen Messung des Abstands zwischen Objekt und Näherungssensor (analoger Sensor). Das Konzept des erfindungsgemäßen induktiven Näherungssensors kann somit sowohl zum Aufbau binärer als auch analoger induktiver Näherungssensoren verwendet werden.

Erfindungsgemäß wird der Schwingkreis in der Rückkoppelschleife des ΣΔ-Modulators vorgesehen, so dass er ein Bestandteil eines Regelkreises wird. Dabei wird dem Schwingkreis mittels Signalrückkopplung über den D/A-Wandler der Betrag an Energie zugeführt, welcher ihm durch in einem Target induzierte Wirbelströme entzogen wird. Dies kann durch eine mit dem Schwingungstakt des Schwingkreises synchronisierte Einspeisung des rückgekoppelten Signals erreicht werden, wobei eine besonders einfache Ausgestaltung vorsieht, dass das rückgekoppelte Signal rechteckförmig ist.

Die Rückkopplung in einer Regelkreisanordnung führt dazu, dass ein Ausgangssignal des Schwingkreises, vorzugsweise die Schwingungsamplitude, auf einen vorgegebenen Sollwert geregelt werden kann. Eine solche Ausführungsform mit Integration des Schwingkreises in einen Regelkreis ermöglichen einen großen Dynamikbereich des induktiven Näherungssensors bezüglich der Dämpfung des Schwingkreises, weil auch große Bedämpfungsänderungen keine negativen Auswirkungen, wie z.B. Schwingungsabriss, verursachen können.

Eine bevorzugte Ausführungsform des erfindungsgemäßen induktiven Näherungssensors sieht die Verwendung eines ΣΔ-Modulators höherer Ordnung vor. Dadurch lässt sich die erzielbare Auflösung des induktiven Näherungssensors weiter erhöhen.

Verschiedene Filtertypen können für das Schleifenfilter vorgesehen sein, wobei ein Tiefpassfilter, im einfachsten Fall ein Integrator, bevorzugt ist. In diesem Fall wird die Regelgröße bevorzugt durch Spitzenwertabtastung ermittelt. Beim Einsatz eines Schleifenfilters mit Bandpasscharakteristik, der ebenso wie ein Schleifenfilter mit Hochpasscharakteristik möglich ist, wird die Regelgröße bevorzugt durch einen digitalen Mischvorgang ermittelt. Das Schleifenfilter kann ein Filter erster oder höherer Ordnung sein.

Insbesondere beim Einsatz eines induktiven Näherungssensors mit einem ΣΔ-Modulator höherer Ordnung kann ein weiteres Filter vorgesehen sein, das bevorzugt zwischen dem Sensorelement und dem Schleifenfilter angeordnet ist und zur Phasenkorrektur dient.

Die erwähnten Filter können kontinuierlich oder diskret aufgebaut sein, wobei eine diskrete Ausführung in der Regel weniger rauschempfindlich ist.

Die Quantisierung der vorgesehenen A/D-Wandler und die Wortbreite der vorgesehenen D/A-Wandler ist grundsätzlich frei wählbar, beträgt aber vorzugsweise jeweils 1 Bit, was den Aufbau vereinfacht und die Wandlungsgeschwindigkeit erhöhen kann.

Die Verwendung von A/D-Wandlern und D/A-Wandlern mit spannungsbasierten und/oder strombasierten Eingängen bzw. Ausgängen ist möglich und kann daher je nach Anwendungsfall vorteilhaft gewählt werden.

Die Aufgabe wird weiterhin mit einem Verfahren mit den Merkmalen des Anspruches 16 gelöst. Die Vorteile des erfindungsgemäßen Verfahrens und besonders bevorzugte Ausgestaltungen ergeben sich in analoger Weise aus den obigen Schilderungen zu entsprechenden Ausführungsformen der erfindungsgemäßen Vorrichtung und deren Vorteile.

Im Folgenden wird die Erfindung anhand beispielhafter Ausführungsformen unter Bezug auf die beiliegenden schematischen Figuren im Detail erläutert. Dabei zeigen:
- Fig. 1: ein Blockschaltbild eines induktiven Näherungssensors mit einem ΣΔ-Modulator;
- Fig. 2: ein Blockschaltbild einer Ausführungsform des erfindungsgemäßen induktiven Näherungssensors mit dem LC-Schwingkreis im Rückkoppelkreis des ΣΔ-Modulators; und
- Fig. 3: ein Blockschaltbild einer Ausführungsform des erfindungsgemäßen induktiven Näherungssensors auf Basis eines ΣΔ-Modulators höherer Ordnung.

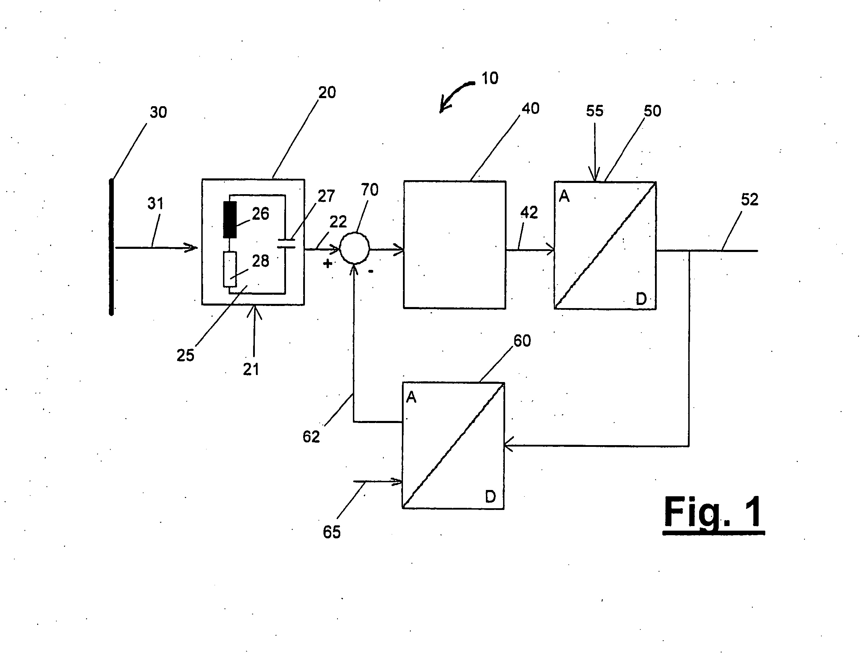

In Fig. 1 ist ein Blockschaltbild eines induktiven Näherungssensors 10 dargestellt. Dieser umfasst ein Sensorelement 20 und einen ΣΔ-Modulator mit einem im einfachsten Fall als Integrator ausgestalteten Schleifenfilter 40, einem A/D-Wandler 50, einem D/A-Wandler 60 und einer Summationsstelle 70.

Das Sensorelement 20 umfasst einen LC-Schwingkreis 25 mit einer Spule 26, einem Kondensator 27 und einem Widerstand 28, der Spulenverluste verdeutlichen soll. Ein Eingang 21 des Sensorelements 20 dient zur Energieversorgung des Sensorelements mit elektrischer Energie, die in an sich bekannter Weise zur Aufrechterhaltung der Schwingung im LC-Schwingkreis eingespeist wird. Das Ausgangssignal 22 entspricht zum Beispiel dem Spannungsverlauf im LC-Schwingkreis. Wenn sich der Abstand 31 zwischen dem Sensorelement 20 und einem Objekt 30 im Wirkungsbereich des magnetischen Wechselfeldes von Spule 26 verändert, ändert sich die Dämpfung und damit die Spannungsamplitude des LC-Schwingkreises. Das Ausgangssignal 22 wird wie folgt mit Hilfe eines ΣΔ-Modulators ausgewertet:

Von dem Ausgangssignal 22 wird in der Summationsstelle 70 der aktuelle Ausgangswert 62 des D/A-Wandlers 60 abgezogen. Die resultierende Differenz durchläuft das Schleifenfilter 40, in dem sie im Wesentlichen integriert wird, und wird anschließend von dem A/D-Wandler 50 in einen digitalen, pulshäufigkeitsmodulierten Datenstrom 52 umgewandelt. Der A/ D-Wandler 50 ist in der bevorzugten Ausführungsform ein einfacher Komparator bzw. 1-Bit A/D-Wandler, der nur über die zwei Zustände "Low" und "High" verfügt. Wenn das integrierte Ausgangssignal 42 des Schleifenfilters 40 größer Null ist, wird der Ausgang 52 beispielsweise auf "High" geschaltet, andernfalls auf "Low".

Der A/D-Wandler 50 arbeitet mit einer Abtastrate 55, die in an sich bekannter Weise um ein Vielfaches höher gewählt wird als durch das Abtasttheorem gefordert, so dass das Ausgangssignal 42 des Schleifenfilters und damit das Ausgangssignal des LC-Schwingkreises überabgetastet wird.

Der pulshäufigkeitsmodulierte Datenstrom 52 wird durch den D/A-Wandler 60, der in der bevorzugten Ausführungsform eine Wortbreite von 1 Bit aufweist, in ein analoges Signal 62 umgewandelt und an die Summationsstelle 70 rückgekoppelt.

Dem D/A-Wandler 60 wird bei der in Fig. 1 gezeigten Ausführungsform ein Spannungs-Referenzwert 65 zur Verfügung gestellt, mit welchem der Spannungspegel des D/A-Wandler-Ausgangssignals 62 eingestellt wird.

Aus der Pulshäufigkeit im Datenstrom 52 kann auf die Schwingungsamplitude des Ausgangssignals 22 des LC-Schwingkreises 25 geschlossen werden. Man erhält so eine Aussage über die Dämpfung des LC-Schwingkreises 25, die durch die Anwesenheit eines Objekts 30 hervorgerufen wird. Eine Auswertung des Datenstroms 52 ermöglicht so die Feststellung, ob ein metallisches Objekt 30 anwesend ist und - bei entsprechender Auflösung - in welchem Abstand 31 es sich befindet.

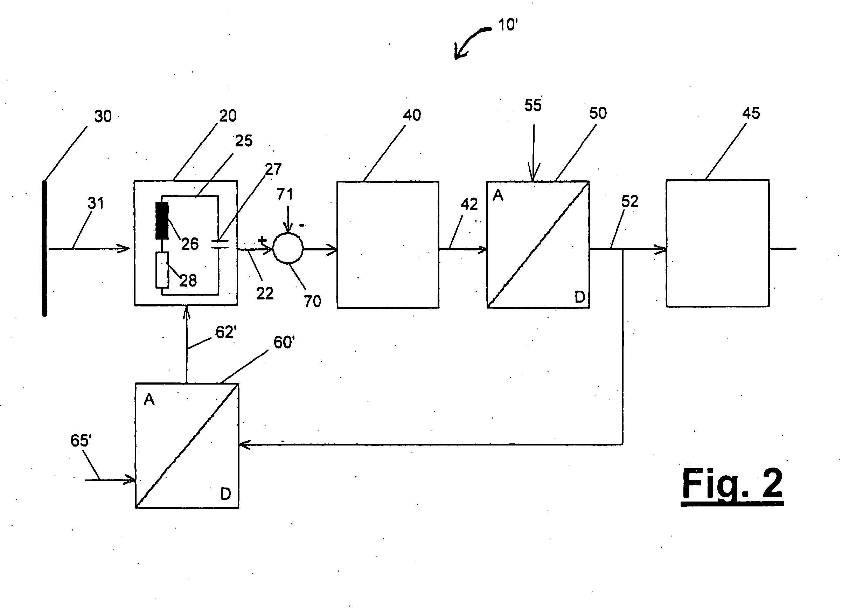

Das Blockschaltbild von Fig. 2 zeigt eine bevorzugte Ausführungsform eines erfindungsgemäßen induktiven Näherungssensors 10' mit einem Sensorelement 20, einem Schleifenfilter 40, einem A/D-Wandler 50, einem D/A-Wandler 60', einer Summationsstelle 70 und einem Dezimationsfilter 45.

In dieser Ausführungsform ist das Sensorelement 20 direkt in die Rückkoppelschleife des ΣΔ-Modulators integriert. An der Summationsstelle 70 wird von dem Ausgangssignal 22 des Sensorelements 20 ein vorgegebener, hier konstant gewählter, Sollwert 71 abgezogen. Die resultierende Differenz wird durch das integrierende Schleifenfilter 40 an den A/D-Wandler 50 geleitet, der wie beschrieben mit dem Arbeitstakt 55 arbeitet. Die vom A/ D-Wandler ausgegebenen digitalen Werte bilden einen pulshäufigkeitsmodulierten Datenstrom 52 am Eingang eines Dezimationsfilters 45. Dieses dient in an sich bekannter Weise zum Ausdünnen redundanter Informationen des pulshäufigkeitsmodulierten Datenstroms 52, die durch Überabtastung bei ΣΔ-Modulatoren entstehen.

Der Datenstrom 52 wird über den D/A-Wandler 60' rückgekoppelt und als analoges Stromsignal 62' in das Sensorelement 20 derart synchronisiert eingespeist, dass immer die von dem LC-Schwingkreis 25 benötigte Energiemenge geliefert wird, um das Ausgangssignal 22 des LC-Schwingkreises 25 auf dem vorgegebenen Sollwert 71 zu halten. Einfacherweise geschieht diese Einspeisung rechteckförmig. Zur Festlegung des Pegels des eingespeisten Stromsignales 62' wird dem D/A-Wandler 60' ein Stromreferenzwert 65' zur Verfügung gestellt.

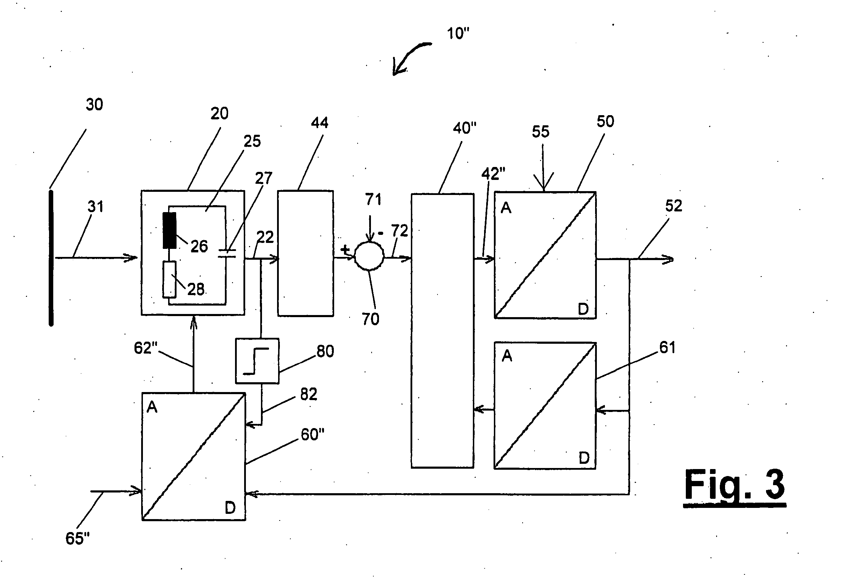

Im Rahmen der Erläuterung der Ausführungsform der Fig. 3 wird eine Umsetzungsmöglichkeit für die Bereitstellung der benötigten Energiemenge aufgezeigt.

Durch die Integration des LC-Schwingkreises in die Rückkoppelschleife des ΣΔ-Modulators wird erreicht, dass das Ausgangssignal 22 des LC-Schwingkreises 25 im Wesentlichen immer auf den vorgegebenen Sollwert 71 geregelt wird, auch wenn die Dämpfung des Schwingkreises 25 durch ein Objekt 30 verändert wird. Dadurch wird eine höhere Dynamik des induktiven Näherungssensors 10' ermöglicht, weil Störungen, z.B. durch Schwingungsabriss, vermieden werden.

Das in Fig. 3 gezeigte Blockschaltbild eines erfindungsgemäßen induktiven Näherungssensors 10" auf Basis eines ΣΔ-Modulators höherer Ordnung zeigt eine weitere bevorzugte Ausführungsform mit einem Sensorelement 20, einem Phasenkorrekturfilter 44, einer Summationsstelle 70, einem Schleifenfilter 40", einem A/D-Wandler 50, D/A-Wandlern 60" und 61 und einem Komparator 80.

Auch in dieser Ausführungsform erhält das Sensorelement 20 die benötigte Energie, um das Ausgangssignal 22 des LC-Schwingkreises 25 nach Vorgabe durch den Sollwert 71 zu führen, von dem Ausgang des D/A-Wandlers 60" in Form eines Stromsignals 62". Der Ausgang 22 des Sensorelements 20 steuert einen Komparator 80 an, der wiederum über einen Ausgang 82 derart auf den D/A-Wandler 60" einwirkt, dass dieser den anliegenden Eingangswert 52 nur dann in einen Analogwert umwandelt und an seinen Ausgang 62" ausgibt, wenn der Komparatorausgang 82 einen entsprechenden Wert aufweist. Der Komparator 80 schaltet dabei seinen Ausgang 82 z.B. auf "High", wenn das Ausgangssignal 22 des LC-Schwingkreises 25 über einer vorgegebenen Schwelle liegt. Andernfalls schaltet der Komparator 80 auf "Low".

Der Ausgang 22 des Sensorelements 20 durchläuft das optionale Phasenkorrekturfilter 44, das in an sich bekannter Weise der durch die Module höherer Ordnung verursachten erhöhten Phasendrehung entgegenwirkt und somit im Wesentlichen zur Stabilisierung des ΣΔ-Modulators höherer Ordnung dient. An der Summationsstelle 70 wird zur Bildung des Differenzsignals 72 der Sollwert 71 abgezogen.

Das Schleifenfilter 40" ist in dieser Ausführungsform ein Filter höherer Ordnung, durch welches das Differenzsignal 72 geleitet wird. Der Ausgang 42" wird an den A/D-Wandler 50 geleitet, der mit dem Arbeitstakt 55 arbeitet, wodurch in beschriebener Weise ein pulshäufigkeitsmodulierter Datenstrom 52 entsteht. Dieser wird einerseits über den D/A-Wandler 61 zurück an das Schleifenfilter 40" geleitet und andererseits, wie bei einem einstufigen ΣΔ-Modulator, an den D/A-Wandler 60", dessen Stromausgangssignal 62" in beschriebener Weise in den LC-Schwingkreis 25 eingespeist wird.

Der Vorteil der in dieser Ausführungsform verwendeten Architektur des ΣΔ-Modulators höherer Ordnung liegt im Wesentlichen in einer damit erreichbaren weiteren Erhöhung der Auflösung des pulshäufigkeitsmodulierten Datenstroms 52.

Die besprochenen beispielhaften Ausführungsformen können in verschiedenen Variationen umgesetzt bzw. kombiniert werden. So ist es beispielsweise möglich, die Schleifenfilter 40, 40", und das Phasenkorrekturfilter 44 als diskrete Filter oder als kontinuierliche Filter auszuführen. Desweiteren wird als Filtercharakteristik für die Schleifenfilter 40 und 40" bevorzugt ein Tiefpass verwendet, jedoch sind sowohl ein Bandpass wie auch ein Hochpass möglich.

Auch ist es möglich, die Quantisierung des A/D-Wandlers 50 und die Wortbreite der D/A-Wandler 60, 60', 60" und 61 auf von 1 Bit verschiedene Werte zu setzen, obwohl 1 Bit aufgrund der Einfachheit des Aufbaus bevorzugt ist.

Schließlich ist es möglich, die Eingänge und die Ausgänge der D/A-Wandler 60, 60', 60" und 61 jeweils strombasiert oder spannungsbasiert aufzubauen. So wurde z.B. die Ausführungsform der Fig. 2 und 3 derart geschildert, dass am jeweiligen Referenzeingang 65', 65" des D/A-Wandlers 60', 60" ein Stromwert anliegt und der jeweilige Ausgang 62', 62" ebenfalls ein Stromwert ist, während der Eingang des D/A-Wandlers 60', 60" spannungsbasiert ist. Bei der Ausführungsform der Fig. 1 werden alle Eingänge und Ausgänge als spannungsbasiert geschildert. Andere Kombinationen sind bei entsprechender Ausgestaltung jedoch ebenfalls möglich.

### Bezugszeichenliste

- 10, 10', 10": induktiver Näherungssensor
- 20: Sensorelement
- 21: Eingang des Sensorelements
- 22: Ausgang des Sensorelements
- 25: LC-Schwingkreis
- 26: Spule
- 27: Kondensator
- 28: Widerstand
- 30: Target, Objekt
- 31: Abstand zwischen Objekt und Sensorelement
- 40, 40": Schleifenfilter
- 42, 42": Schleifenfilterausgang
- 44: Phasenkorrekturfilter
- 45: Dezimationsfilter
- 50: A/D-Wandler (Analog/Digital-Wandler)
- 52: pulshäufigkeitsmodulierter Datenstrom
- 55: Abtastrate
- 60, 60', 60": D/A-Wandler (Digital/Analog-Wandler)
- 61: D/A-Wandler (Digital/Analog-Wandler)
- 62, 62', 62": D/A-Wandlerausgang
- 65, 65', 65": Referenzwert für D/A-Wandler
- 70: Summationsstelle
- 71: Sollwert
- 72: Differenzsignal
- 80: Komparator
- 82: Komparatorausgang

## Patentansprüche

1. Induktiver Näherungssensor zur Feststellung der Anwesenheit und/oder des Abstands eines elektrisch leitfähigen Objekts (30) mit einem Sensorelement (20), das einen Schwingkreis, insbesondere einen LC-Schwingkreis (25), umfasst, der ein Ausgangssignal zur Verfügung stellt, das von der Bedämpfung durch ein elektrisch leitfähiges Objekt (30) abhängt, und einem ΣΔ-Modulator zur Auswertung eines Ausgangssignals (22) des Schwingkreises (25), wobei der ΣΔ-Modulator eine Rückkoppelschleife aufweist, die wenigstens ein Schleifenfilter (40,40"), wenigstens einen A/D-Wandler (50) und wenigstens einen D/A-Wandler (60, 60', 60") umfasst,
**dadurch gekennzeichnet, dass**
der Schwingkreis (25) in der Rückkoppelschleife des ΣΔ-Modulators vorgesehen ist.

2. Induktiver Näherungssensor nach Anspruch 1, **dadurch gekennzeichnet, dass**
das Ausgangssignal (22), vorzugsweise dessen Schwingungsamplitude, des Schwingkreises (25) im Rückkoppelkreis des ΣΔ-Modulators auf einen vorgegebenen Sollwert (71) geregelt wird.

3. Induktiver Näherungssensor nach einem der Ansprüche 1 oder 2,
**dadurch gekennzeichnet, dass**
die Rückkoppelschleife des ΣΔ-Modulators derart ausgestaltet ist,
ein Signal (62', 62") zur Verfügung zu stellen, das in den Schwingkreis (25) des Sensorelementes (20) zum Ausgleich einer durch die Anwesenheit eines metallischen Objekts (30) hervorgerufenen Bedämpfung eingespeist wird.

4. Induktiver Näherungssensor nach Anspruch 3, **dadurch gekennzeichnet, dass**
die Einspeisung des Signals (62', 62") mit dem Schwingungstakt des Schwingkreises (25) synchronisiert erfolgt.

5. Induktiver Näherungssensor nach Anspruch 4, **dadurch gekennzeichnet, dass**
das eingespeiste Signal (62', 62") rechteckförmig ist.

6. Induktiver Näherungssensor nach einem der vorhergehenden Ansprüche,
**dadurch gekennzeichnet, dass** der ΣΔ-Modulator ein ΣΔ-Modulator höherer Ordnung ist.

7. Induktiver Näherungssensor nach einem der vorhergehenden Ansprüche,
**dadurch gekennzeichnet, dass** das Schleifenfilter (40, 40") des ΣΔ-Modulators eine Tiefpasscharakteristik aufweist.

8. Induktiver Näherungssensor nach einem der Ansprüche 1 bis 6,
**dadurch gekennzeichnet, dass** das Schleifenfilter (40, 40") des ΣΔ-Modulators eine Bandpasscharakteristik aufweist.

9. Induktiver Näherungssensor nach einem der vorherigen Ansprüche, bei dem das Schleifenfilter (40") einen Filter höherer Ordnung umfasst.

10. Induktiver Näherungssensor nach einem der vorherigen Ansprüche,
**dadurch gekennzeichnet, dass** in der Rückkoppelschleife des ΣΔ-Modulators, vorzugsweise zwischen dem Sensorelement (20) und dem Schleifenfilter (40"), ein Phasenkorrekturfilter (44) vorgesehen ist.

11. Induktiver Näherungssensor nach Anspruch 10,
**dadurch gekennzeichnet, dass** das Phasenkorrekturfilter (44) diskret ausgeführt ist.

12. Induktiver Näherungssensor nach einem der vorherigen Ansprüche,
**dadurch gekennzeichnet, dass** das Schleifenfilter (40, 40") diskret ausgeführt ist.

13. Induktiver Näherungssensor nach einem der vorhergehenden Ansprüche,
**dadurch gekennzeichnet, dass** die Quantisierung des wenigstens einen A/D-Wandlers (50) und/oder die Wortbreite des wenigstens einen D/A-Wandlers (60, 60', 60", 61) 1 Bit beträgt.

14. Induktiver Näherungssensor nach einem der vorhergehenden Ansprüche,
**dadurch gekennzeichnet, dass** der Ausgang des wenigstens einen D/A-Wandlers (60, 60', 60") strombasiert ist.

15. Verfahren zur Feststellung der Anwesenheit und/oder des Abstandes eines metallischen Objektes mit Hilfe eines induktiven Näherungssensors (10', 10"), bei dem von dem Ausgangssignal (22) eines gegebenenfalls durch die Anwesenheit eines metallisches Objekt (30) bedämpften Schwingkreises (25) ein Sollwert (71) abgezogen wird, die resultierende Differenz gefiltert und zu einem pulshäufigkeitsmodulierten Ausgangssignal (52) digitalisiert wird, wobei das pulshäufigkeitsmodulierte Ausgangssignal (52) nach Durchlaufen eines Digital/Analog-Wandlers (60', 60") synchron mit dem Schwingungstakt des Schwingkreises (25) in diesen zurückgekoppelt wird.

## Claims

1. An inductive proximity sensor for the determination of the presence and/or of the spacing of an electrically conductive object (30), there being a sensor element (20) which includes a resonant circuit, in particular an LC resonant circuit (25) which provides an output signal which depends on the damping by an electrically conductive object (30), and a ΣΔ modulator for the evaluation of an output signal (22) of the resonant circuit (25), with the ΣΔ modulator having a feedback loop which includes at least one loop filter (40, 40"), at least one A/D converter (50) and at least one D/A converter (60, 60', 60"),
**characterized in that** the resonant circuit (25) is provided in the feedback loop of the ΣΔ modulator.

2. An inductive proximity switch in accordance with claim 1, **characterized in that** the output signal (22), preferably its oscillation amplitude, of the resonant circuit (25) is controlled to a preset desired value (71) in the feedback circuit of the ΣΔ modulator.

3. An inductive proximity sensor in accordance with claim 1 or claim 2,
**characterized in that** the feedback loop of the ΣΔ modulator is designed to make available a signal (62', 62") which is fed into the resonant circuit (25) of the sensor element (20) for the compensation of a damping caused by the presence of a metallic object (30).

4. An inductive proximity switch in accordance with claim 3, **characterized in that** the feed of the signal (62', 62") takes place synchronized with the resonant cycle of the resonant circuit (25).

5. An inductive proximity switch in accordance with claim 4, **characterized in that** the fed in signal (62', 62") is rectangular.

6. An inductive proximity sensor in accordance with any one of the preceding claims, **characterized in that** the ΣΔ modulator is a higher order ΣΔ modulator.

7. An inductive proximity sensor in accordance with any one of the preceding claims, **characterized in that** the loop filter (40, 40") of the ΣΔ modulator has a low pass characteristic.

8. An inductive proximity sensor in accordance with any one of the claims 1 to 6, **characterized in that** the loop filter (40, 40") of the ΣΔ modulator has a band pass characteristic.

9. An inductive proximity sensor in accordance with any one of the preceding claims, wherein the loop filter (40") includes a higher order filter.

10. An inductive proximity sensor in accordance with any one of the preceding claims, **characterized in that** a phase correction filter (44) is provided in the feedback loop of the ΣΔ modulator, preferably between the sensor element (20) and the loop filter (40").

11. An inductive proximity sensor in accordance with claim 10, **characterized in that** the phase correction filter (44) is made as a discrete phase correction filter.

12. An inductive proximity sensor in accordance with any one of the preceding claims, **characterized in that** the loop filter (40, 40") is made as a discrete loop filter.

13. An inductive proximity sensor in accordance with any one of the preceding claims, **characterized in that** the quantization of the at least one A/ D converter (50) and/ or the word width of the at least one D/A converter (60, 60' 60", 61) amounts to 1 bit.

14. An inductive proximity sensor in accordance with any one of the preceding claims, **characterized in that** the output of the at least one D/A converter (60, 60', 60") is current based.

15. A method for the determination of the presence and/or of the spacing of a metallic object with the help of an inductive proximity sensor (10', 10"), wherein a desired value (71) is deducted from the output signal (22) of a resonant circuit (25) which may be damped by the presence of a metallic object (30), the resulting difference is filtered and is digitized to a pulse occurrence modulated output signal (52), wherein the pulse occurrence modulated output signal (52) is fed back into the resonant circuit synchronously with the resonant cycle of the resonant circuit (25) after running through a digital/analog converter (60'/60").

## Revendications

1. Capteur de proximité inductif pour constater la présence et/ou la distance d'un objet électriquement conducteur (30), comprenant un élément détecteur (20) qui comprend un circuit oscillant, en particulier un circuit oscillant LC (25), qui met à disposition un signal de sortie qui dépend de l'amortissement à travers un objet électriquement conducteur (30), et un modulateur ΣΔ pour l'évaluation d'un signal de sortie (22) du circuit oscillant (25), ledit modulateur ΣΔ comprenant une boucle de rétroaction qui inclut au moins un filtre en boucle (40, 40"), au moins un convertisseur A/N (50) et au moins un convertisseur N/A (60, 60', 60"),
**caractérisé en ce que**
le circuit oscillant (25) est prévu dans la boucle de rétroaction du modulateur ΣΔ.

2. Capteur de proximité inductif selon la revendication 1, **caractérisé en ce que**
le signal de sortie (22), de préférence son amplitude d'oscillation, du circuit oscillant (25) dans le circuit de rétroaction du modulateur ΣΔ est régulé à une valeur de consigne prédéterminée (71).

3. Capteur de proximité inductive selon l'une des revendications 1 ou 2,
**caractérisé en ce que**
la boucle de rétroaction du modulateur SD est conçue de manière à mettre à disposition un signal (62', 62") qui est injecté dans le circuit oscillant (25) de l'élément détecteur (20) pour la compensation d'un amortissement provoqué par la présence d'un objet métallique (30).

4. Capteur de proximité inductif selon la revendication 3, **caractérisé en ce que**
l'injection du signal (62', 62") a lieu de manière synchronisée avec la cadence d'oscillation du circuit oscillant (25).

5. Capteur de proximité inductif selon la revendication 4, **caractérisé en ce que**
le signal injecté (62', 62") est de forme rectangulaire.

6. Capteur de proximité inductif selon l'une des revendications précédentes,
**caractérisé en ce que** le modulateur ΣΔ est un modulateur ΣΔ d'ordre supérieur.

7. Capteur de proximité inductif selon l'une des revendications précédentes,
**caractérisé en ce que** le filtre en boucle (40, 40") du modulateur ΣΔ présente une caractéristique passe-bas.

8. Capteur de proximité inductif selon l'une des revendications 1 à 6,
**caractérisé en ce que** le filtre en boucle (40, 40") du modulateur ΣΔ présente une caractéristique de bande passante.

9. Capteur de proximité inductif selon l'une des revendications précédentes,
dans lequel le filtre en boucle (40") comprend un filtre d'ordre supérieur.

10. Capteur de proximité inductif selon l'une des revendications précédentes,
**caractérisé en ce qu'**il est prévu un filtre correcteur de phase (44) dans la boucle de rétroaction du modulateur ΣΔ, de préférence entre l'élément détecteur (20) et le filtre en boucle (40").

11. Capteur de proximité inductif selon la revendication 10,
**caractérisé en ce que** le filtre correcteur de phase (44) est réalisé de manière discrète.

12. Capteur de proximité inductif selon l'une des revendications précédentes,
**caractérisé en ce que** le filtre en boucle (40, 40") est réalisé de manière discrète.

13. Capteur de proximité inductif selon l'une des revendications précédentes,
**caractérisé en ce que** la quantification dudit au moins un convertisseur A/N (50) et/ou la largeur de mot dudit au moins un convertisseur N/A (60, 60', 60", 61) s'élève à 1 bit.

14. Capteur de proximité inductif selon l'une des revendications précédentes,
**caractérisé en ce que** la sortie dudit au moins un convertisseur N/A (60, 60', 60") est basée sur le courant.

15. Procédé pour déterminer la présence et/ou la distance d'un objet métallique à l'aide d'un capteur de proximité inductif (10', 10"), dans lequel une valeur de consigne (71) est soustraite du signal de sortie (22) d'un circuit oscillant (25), le cas échéant amorti par la présence d'un objet métallique (30), la différence résultante est filtrée et numérisée en un signal de sortie (52) modulé en fréquence d'impulsion, dans lequel le signal de sortie (52) modulé en fréquence d'impulsion est à nouveau injecté en rétroaction dans le circuit oscillant (25), de manière synchrone à la cadence d'oscillation du circuit oscillant (25) après avoir traversé un convertisseur numérique/analogique (60', 60").
